# EUROPEAN PATENT APPLICATION

(11) **EP 1 667 233 A2**
(43) Date of publication of application: **07.06.2006**
(21) Application number: 05257097.5
(22) Date of filing: 17.11.2005
(51) Int. Cl.: H01L 27/146

(54) **Image sensor and pixel having a polysilicon layer over the photodiode**

(30) Priority: 03.12.2004 US 3298
(71) Applicant: OmniVision Technologies, Inc., Sunnyvale, California 94089 (US)
(72) Inventor: Rhodes, Howard E., Boise Idaho 83706 (US)
(74) Representative: Hackney, Nigel John

(57) **Abstract**

A pixel for use in CMOS or CCD image sensors is disclosed. The pixel includes a light sensitive element, such as a photodiode, formed in a semiconductor substrate. A polysilicon layer, such as a P⁺ doped polysilicon, is formed over the photodiode to reduce reflection of incident light and acting as a pinning layer. The reduced reflection results in greater "signal" reaching the photodiode.

## Description

The present invention relates to image sensors, and more particularly, to an image sensor that uses pixels having a polysilicon layer atop of the photodiode.

Image sensors have become ubiquitous. They are widely used in digital still cameras, cellular phones, security cameras, medical, automobile, and other applications. The technology used to manufacture image sensors, and in particular CMOS image sensors, has continued to advance at great pace. For example, the demands of higher resolution and lower power consumption have encouraged the further miniaturization and integration of the image sensor.

As the pixels become smaller, the surface area that can receive incident light is also reduced. The pixel typically has a light-sensing element, such as a photodiode, which receives incident light and produces a signal in relation to the amount of incident light. Because of the small size of the light-sensing element, it is important that as much incident light is captured by the light-sensing element. One major source of incident light loss occurs as a result of reflection at the photodiode (the silicon surface) to oxide (SiO₂) interface. At this interface, a substantial amount of light is reflected with the consequential reduction in photodiode responsivity and quantum efficiency.

Further, as the pixel area (and thus the photodiode area) decreases, the well capacity of the photodiode also becomes smaller. One prior art structure of a photodiode that has enhanced well capacity comprises a shallow N⁻ region in a P-type region or substrate. A P⁺ pinning layer is then formed over the shallow N⁻ region by implanting a p-type dopant (such as boron) into the shallow N⁻ region. This structure is known as a pinned photodiode and has relatively high well capacity, but sometimes at the expense of "dark current" performance and excess "hot pixel" defects.

In general, it is advantageous for the P⁺ implant to be very shallow. Having a shallow P⁺ surface implant enables the N⁻ region to also be shallow. This in turn increases the capacitance of the photodiode for improved sensitivity and full well capacity and improves image lag by providing a N-implant that links up with the transfer gate in four-transistor (4T) pixel architectures.

In a first aspect, the present invention provides a pixel according to Claim 1. Other aspects will be apparent from the attached claims.

### BRIEF DESCRIPTION OF THE DRAWINGS

Figure 1 is a combination cross-sectional and schematic diagram of a prior art four transistor (4T) pixel which shows in detail a photodiode formed in a substrate.
Figure 1A is a combination cross-sectional and schematic diagram of a prior art three transistor (3T) pixel which shows in detail a photodiode formed in a substrate.
Figure 2 is a cross-sectional diagram of a 4T pixel having an anti-reflective coating (ARC).

Figures 3-7 are cross sectional views illustrating the process of manufacturing a pixel with a P⁺ doped polysilicon pinning layer in accordance with the present invention.

Figures 8-11 are cross sectional views illustrating an alternative process for manufacturing a pixel with a P⁺ doped polysilicon pinning layer.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

Referenced throughout the specification to "one embodiment" or "an embodiment" means that a particular feature, structure, or characteristic described in connection with the embodiment and included in at least one embodiment of the present invention. Thus, the appearances of the phrase "in one embodiment" or "in an embodiment" in various places throughout the specification are not necessarily all referring to the same embodiment. Furthermore, the particular features, structures, or characteristics may be combined in any suitable manner in one or more embodiments.

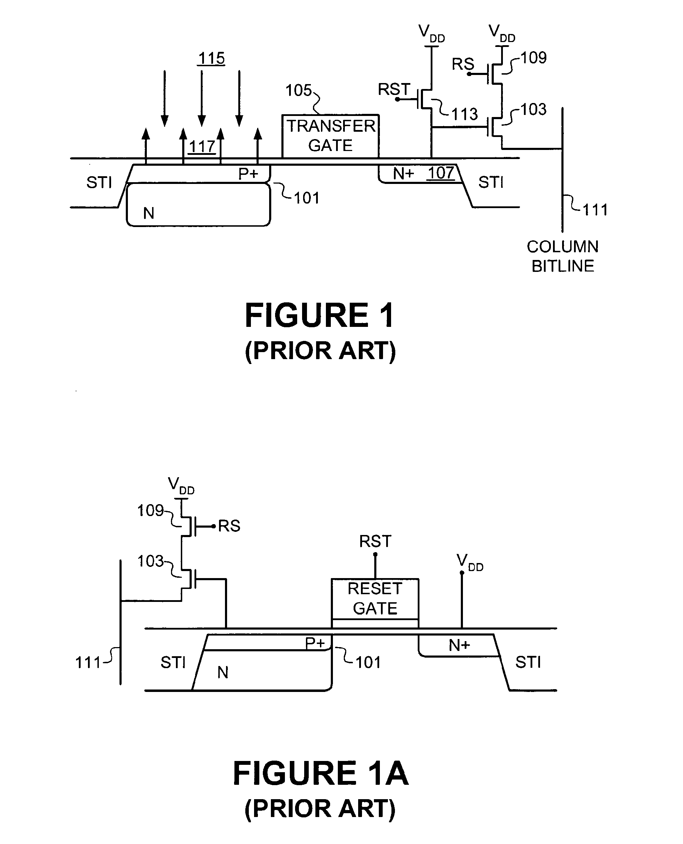

Figure 1 shows a combination cross-sectional and schematic view of an active pixel that uses four transistors. This is known in the art as a 4T active pixel. A light-sensing element, in this embodiment a photodiode 101, outputs a signal that is used to modulate an amplification transistor 103. The amplification transistor 103 is also referred to as a source follower transistor. While the light-sensing element can be one of a variety of devices, including without limitation, photogates, photodiodes, pinned photodiodes, partially pinned photodiodes, etc., in the present invention, the light-sensing element is a photodiode (whether of the pinned or partially pinned variety). A transfer transistor 105 is used to transfer the signal output by the photodiode 101 to a floating node 107, which is connected to the gate of the amplification transistor 103. The transfer transistor 105 is controlled by a transfer gate.

A characteristic feature of a 4T active pixel is the presence of a transfer gate to enable true correlated double sampling (CDS). It is possible to eliminate the row select (RS) transistor in the 4T pixel to form a "4T active pixel" with just three transistors by additionally gating the supply voltage to the reset transistors. It is to be understood that this invention applies to all CMOS imagers whether they be formed with 3, 4, 5, 6, 7, or more transistors. This invention also applies to CCD image sensors.

In operation, during an integration period (also referred to as an exposure or accumulation period), the photodiode 101 generates charge that is held in the N-type layer. After the integration period, the transfer transistor 105 is turned on to transfer the charge held in the N-type layer of the photodiode 101 to the floating node 107. After the signal has been transferred to the floating node 107, the transfer transistor 105 is turned off again for the start of a subsequent integration period.

The signal on the floating node 107 is then used to modulate the amplification transistor 103. Finally, an address transistor 109 is used as a means to address the pixel and to selectively read out the signal onto a column bit line 111. After readout through the column bit line 111, a reset transistor 113 resets the floating node 107 to a reference voltage. In one embodiment, the reference voltage is V_{dd}. Note that while the description herein discusses the present invention in the context of a 4T pixel, the present invention may be used with a 3T, 5T, 6T, 7T or other pixel designs. In fact, the use of the present invention may be applied to any light sensing element or with either CMOS or CCD image sensors.

Figure 1A shows a three transistor (3T) pixel design. In this design, the transfer transistor is omitted and the output node of the photodiode is directly connected to the amplification transistor 103. Further, the reset transistor 113 is adjacent the photodiode 101 and can selectively reset the output of the photodiode to the reference voltage V_{dd}.

As can be seen in Figures 1 and 1A, incident light 115 is incident onto the photodiode 101. However, some portion of the incident light 115 is reflected as reflected light 117. This reflected light 117 is "wasted", i.e. not sensed by the photodiode 101.

The present invention reduces the reflection from the surface of the photodiode 101 by adding a rough polysilicon layer. In one embodiment, the rough polysilicon layer may be doped with a p-type dopant. Such a P⁺ doped rough polysilicon layer serves at least two purposes: (1) reduces wasted incident light and (2) acts as a P⁺ pinning layer. Note that while the description herein shows the application of the present invention with respect to CMOS pixels, the present invention can be equally applied to CCD pixels.

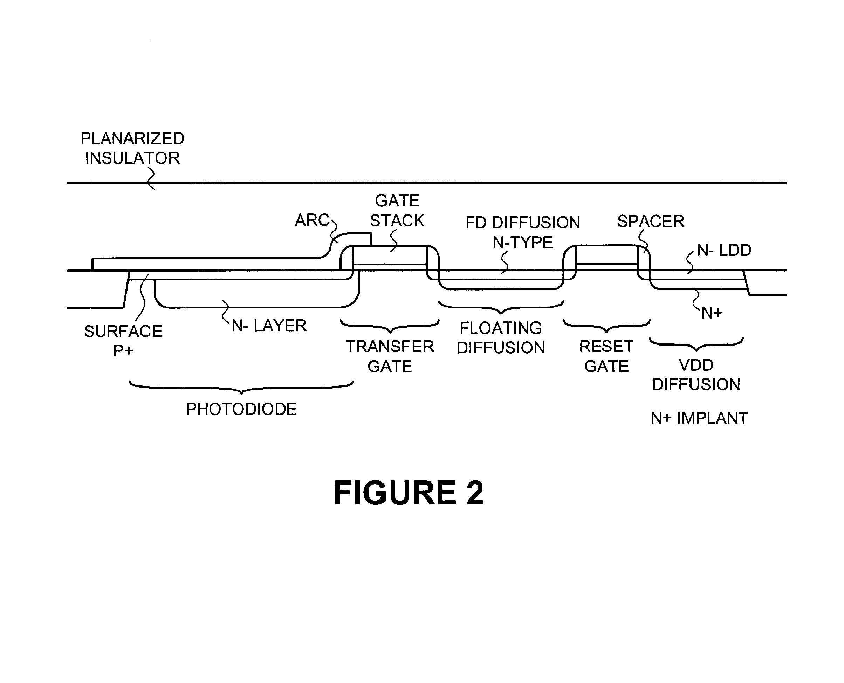

In one embodiment, the P⁺ doped polysilicon layer is placed close to the silicon surface and over the photodiode 101. Note importantly, that the P⁺ doped polysilicon layer can reduce reflection at the substrate/oxide boundary not only for a particular wavelength, but over a wide range of wavelengths. Thus, the present invention has advantages over the use of an anti-reflection coating (ARC). Specifically, Figure 2 shows a typical 4T pixel that uses an ARC over the photodiode region. The ARC has a thickness that is closely correlated to a particular wavelength that is to be affected. Thus, the ARC and structure shown in Figure 2 are not optimized over a wide range of incident wavelengths.

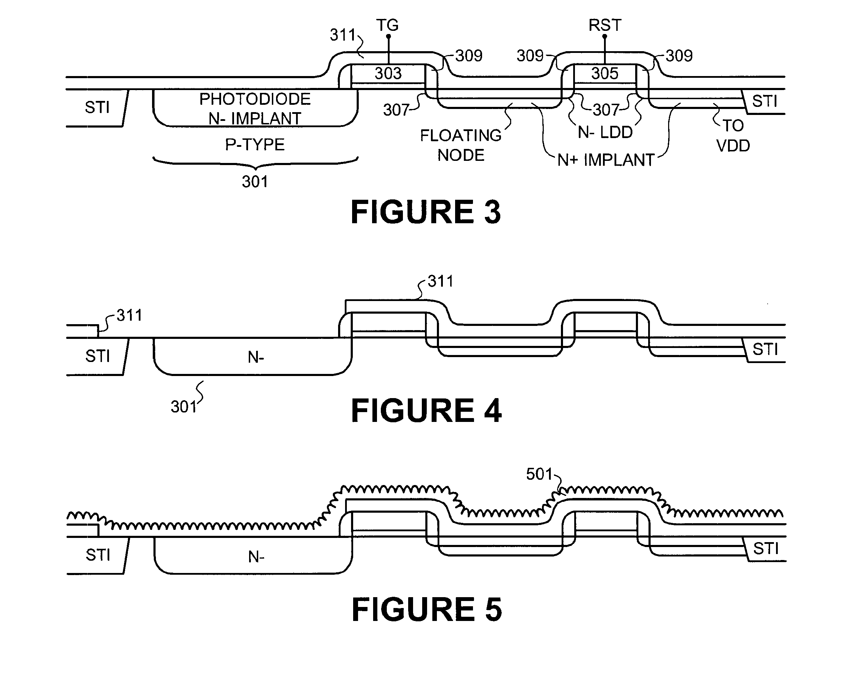

As seen in Figure 3, a portion of a 4T pixel is shown with a photodiode 301 formed in a p-type substrate or region. The pixel is bordered by a field oxide, in this example, a shallow trench isolation (STI). Further, the photodiode 301 shown in Figures 3-7 is a pinned photodiode. However, it can be appreciated that the present invention can be applied to any type of light-sensing element. In the example of Figures 3-7 showing a pinned photodiode, the P⁺ doped rough polysilicon layer (described below) also serves as the pinning layer. Also shown in Figure 3 is the transfer transistor 303 that has its transfer gate controlled by a signal TG. Moreover, a reset transistor 305 is formed adjacent to the transfer transistor 303. The gate of the reset transistor is controlled by the signal RST.

Still referring to Figure 3, various conventional steps are performed to form lightly doped drain regions 307 adjacent the transfer gate 303 and reset gate 305. Further, sidewall spacers 309 are formed on the sidewalls of the transfer and reset gates. Finally, and N⁺ regions are formed adjacent the transfer and reset gates to serve as the floating node and the connection to V_{dd}. These structures, and the steps used to form them, are conventional in the prior art, but are briefly described herein for completeness. Still, there may be additional steps, such as enhancement implants, P-well implants, and lightly doped drain (LDD) implants that are well known in the art that have been omitted to avoid obscuring the present invention.

Next, in accordance with one method of the present invention, an insulator layer 311 is deposited. The insulator layer 311 is typically an oxide layer that can be formed by deposition, such as by a chemical vapor deposition or a plasma-enhanced chemical vapor deposition process. Further, the insulator layer 311 may be the same oxide layer used to form the sidewall spacers (described further below) or the oxide layer used to a resist protect oxide (RPO) used as part of a salicide process. Thus, while the insulator layer 311 may be co-functional with other oxide or dielectric layers, a dedicated insulator layer 311 is shown in Figure 3 to more clearly illustrate the present invention.

One purpose of the insulator layer 311 is to act as a mask for the later formation of the P⁺ doped polysilicon layer. Thus, as seen in Figure 4, the insulator layer 311 is patterned and masked to expose the surface of the photodiode 301. This can be done using conventional masking and etching processes. Further, next turning to Figure 4, a polysilicon layer 501 is deposited. The polysilicon layer 501 in this embodiment is doped with a p-type dopant, such as boron, indium, or boron diflouride (BF₂). The doping may be done insitu with the deposition of the polysilicon layer 501, or alternatively, may be done after deposition of the polysilicon layer 501 with an ion implant process. Still alternatively, the doping may be done using a thermal diffusion process. In one embodiment, the polysilicon layer 501 is a rugged polysilicon (such as that described in U.S. Patent No. 5,869,399) or a hemispherical grain (HSG) polysilicon. This provides a "rough" surface that will tend to cause less overall reflection of incident light.

It should be noted that the polysilicon layer 501 need not be doped with a p-type dopant. This will result in an unpinned photodiode. Alternatively, the polysilicon layer 501 may not be doped. Instead, a separate P⁺ pinning layer may be formed in the semiconductor substrate (such as shown in Figure 1). In short, the polysilicon layer 501 can serve one of at least two purposes, and perhaps both. The polysilicon layer 501 may be an undoped rugged or HSG polysilicon layer, in which case it serves to minimize reflection. The polysilicon layer may be a p-type doped smooth polysilicon layer, in which case it serves as a P⁺ pinning layer that allows a shallow N⁻ region for the photodiode. Finally, as shown in the Figures, the polysilicon layer 501 may be a P⁺ doped rugged or HSG polysilicon layer, in which case reflections are minimized and it acts as a P⁺ pinning layer.

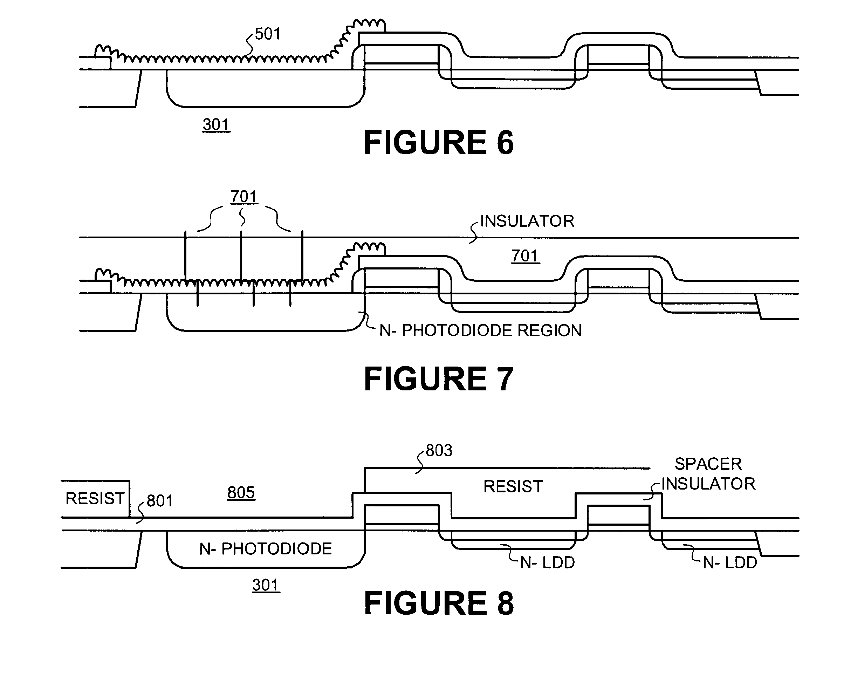

As seen in Figure 6, the polysilicon layer 501 is then patterned and etched so that the polysilicon layer 501 is only primarily over the photodiode 301. Note that the polysilicon layer 501 has a substantial roughness due to the use of HSG or rugged polysilicon.

As seen in Figure 7, the roughness provides increased internal reflection from one grain to another grain that increases the probability of transmission to the photodiode 301. The roughness of the polysilicon grains can be controlled primarily through the deposition temperature. Finally, as further seen in Figure 7, a second insulator layer 701 is deposited over the pixel structure to planarize and protect the underlying structure.

A second method of forming the structure of the present invention is shown in Figures 8-11. Specifically, as seen in Figure 8, first a spacer insulator layer 801 is deposited over the pixel structure. Then, a photoresist layer 803 having an opening 805 over the photodiode 301 is deposited.

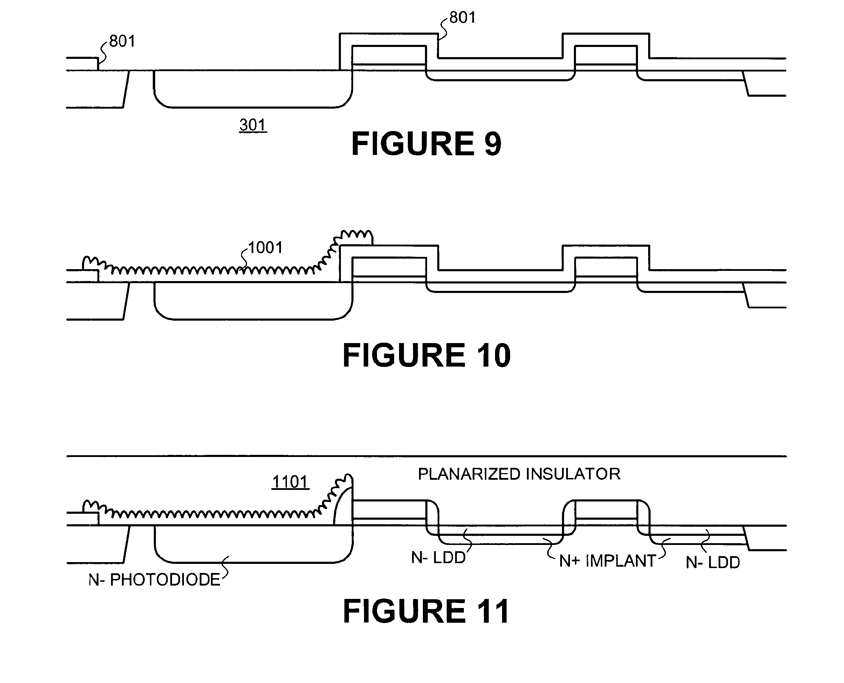

Then, at Figure 9, the spacer insulator layer 801 over the photodiode 301 is removed using the photoresist layer 803 as a mask. After the etching of the spacer insulator layer 801, the photoresist layer 803 is removed.

Next, as seen in Figure 10, a polysilicon layer 1001 is deposited over the pixel. The polysilicon layer 1001 is then patterned and etched to remove those portions of the polysilicon layer 1001 not over the photodiode area. During this patterning and etching of the polysilicon layer 1001, the underlying spacer insulator layer 801 not protected by the photoresist is also etched back to form sidewall spacers. The result is shown in Figure 11, which also includes a formation of a planarizing insulator layer 1101 over the pixel.

From the foregoing, it will be appreciated that specific embodiments of the invention have been described herein for purposes of illustration, but that various modifications may be made without deviating from the spirit and scope of the invention.

For example, it may be possible to use the concepts of the present invention with NPN pinned photodiodes, where the dopant types are switched from that shown in the Figures. Specifically, the pixel may use p-channel transistors and the photodiode may be formed from a shallow P⁻ region formed in an n-type substrate (or N-well). The pinning layer may then be formed from an N⁺ doped polysilicon (rugged or hemispherical or smooth) layer. Thus, the methods and teachings of the present invention may be applied to devices of reverse polarity from that described above and shown in the drawings. Further, the term rugged polysilicon is meant to encompass any type of polysilicon that has a substantially rough surface.

Accordingly, the invention is not limited except as by the appended claims.

## Claims

1. A pixel comprising:
a light sensitive element formed in a semiconductor substrate; and
a p-type doped polysilicon layer formed atop said light sensing element.

2. The pixel of Claim 1 further including:
a transfer transistor formed between said light sensitive element and a floating node and selectively operative to transfer a signal from said light sensing element to said floating node; and
an amplification transistor controlled by said floating node.

3. The pixel of Claim 1 further including:
a reset transistor formed between said light sensitive element and a node and selectively operative to reset said node to a reference voltage; and
an amplification transistor controlled by said node.

4. The pixel of Claim 1 wherein said light sensing element is a photodiode.

5. The pixel of Claim 1 wherein said polysilicon layer is a rugged polysilicon layer.

6. The pixel of Claim 1 wherein said polysilicon layer is a hemispherical grain polysilicon layer.

7. The pixel of Claim 1 incorporated into a CMOS image sensor.

8. The pixel of Claim 1 incorporated into a CCD image sensor.

9. The pixel of Claim 1 wherein said pixel is a part of a 3T, 4T, 5T, 6T, or 7T architecture.

10. The pixel of Claim 1 wherein said p-type doped polysilicon layer is doped by implantation.

11. The pixel of Claim 10 wherein said implantation uses boron, indium, or boron diflouride.

12. The pixel of Claim 1 wherein said p-type doped polysilicon is doped using a thermal diffusion process.

13. A pixel comprising:
a light sensitive element formed in a semiconductor substrate; and
a rugged or hemispherical grain polysilicon layer formed atop said light sensing element.

14. The pixel of Claim 13 further including:
a transfer transistor formed between said light sensitive element and a floating node and selectively operative to transfer a signal from said light sensing element to said floating node; and
an amplification transistor controlled by said floating node.

15. The pixel of Claim 13 further including:
a reset transistor formed between said light sensitive element and a node and selectively operative to reset said node to a reference voltage; and
an amplification transistor controlled by said node.

16. The pixel of Claim 13 wherein said light sensing element is a photodiode.

17. The pixel of Claim 13 incorporated into a CMOS image sensor.

18. The pixel of Claim 13 incorporated into a CCD image sensor.

19. The pixel of Claim 13 wherein said pixel is a part of a 3T, 4T, 5T, 6T, or 7T architecture.

20. A pixel comprising:
a light sensitive element formed in a semiconductor substrate; and
a p-type doped rugged or hemispherical grain polysilicon layer formed atop said light sensing element.

21. The pixel of Claim 20 further including:
a transfer transistor formed between said light sensitive element and a floating node and selectively operative to transfer a signal from said light sensing element to said floating node; and
an amplification transistor controlled by said floating node.

22. The pixel of Claim 20 further including:
a reset transistor formed between said light sensitive element and a node and selectively operative to reset said node to a reference voltage; and
an amplification transistor controlled by said node.

23. The pixel of Claim 20 wherein said light sensing element is a photodiode.

24. The pixel of Claim 20 incorporated into a CMOS image sensor.

25. The pixel of Claim 20 incorporated into a CCD image sensor.

26. The pixel of Claim 20 wherein said pixel is a part of a 3T, 4T, 5T, 6T, or 7T architecture.

27. The pixel of Claim 20 wherein said p-type doped polysilicon layer is doped by implantation.

28. The pixel of Claim 27 wherein said implantation uses boron, indium, or boron diflouride.

29. The pixel of Claim 20 wherein said p-type doped polysilicon is doped using a thermal diffusion process.

30. A method of forming a photodiode comprising in a p-type substrate comprising:
forming a N⁻ region in said p-type substrate; and
forming a polysilicon layer over said N⁻ region.

31. The method of Claim 30 wherein said polysilicon layer is rugged polysilicon or hemispherical grain polysilicon.

32. The method of Claim 30 further including:
forming a transfer transistor formed between said photodiode and a floating node and selectively operative to transfer a signal from said photodiode to said floating node; and
forming an amplification transistor controlled by said floating node.

33. The method of Claim 30 further including:
forming a reset transistor between said photodiode and a node and selectively operative to reset said node to a reference voltage; and
forming an amplification transistor controlled by said node.

34. The method of Claim 30 further wherein during the process of forming said polysilicon layer, a p-type dopant is used to insitu dope said polysilicon layer.

35. The method of Claim 30 further including the step of doping said polysilicon layer with a p-type dopant.

36. A method of forming a photodiode comprising in an n-type substrate comprising:
forming a P⁻ region in said n-type substrate; and
forming a polysilicon layer over said P⁻ region.

37. The method of Claim 36 wherein said polysilicon layer is rugged polysilicon or hemispherical grain polysilicon.

38. The method of Claim 36 further wherein during the process of forming said polysilicon layer, a n-type dopant is used to insitu dope said polysilicon layer.

39. The method of Claim 36 further including the step of doping said polysilicon layer with a n-type dopant.

40. A pixel comprising:
a photodiode formed in a semiconductor substrate; and
an n-type doped polysilicon layer formed atop said light sensing element.

41. The pixel of Claim 40 wherein said polysilicon layer is a rugged polysilicon layer.

42. A pixel comprising:
a light sensitive element formed in a semiconductor substrate; and
an n-type doped rugged or hemispherical grain polysilicon layer formed atop said light sensing element.

43. The pixel of Claim 42 wherein said n-type doped rugged or hemispherical grain polysilicon layer is N⁺ doped.
